# EUROPEAN PATENT APPLICATION

(11) **EP 4 768 963 A1**
(43) Date of publication of application: **01.07.2026**
(21) Application number: 25831003.6
(22) Date of filing: 10.04.2025
(51) Int. Cl.: G01R 31/392, G01R 31/367, G01R 31/396, G01R 31/36, G01R 31/385

(54) **BATTERY MANAGEMENT DEVICE, BATTERY MANAGEMENT METHOD, AND BATTERY MANAGEMENT SYSTEM**

(30) Priority: 20.06.2024 KR 20240080287
(71) Applicant: LG Energy Solution, Ltd., Seoul 07335 (KR)
(72) Inventor: KIM, Young Joong, Daejeon 34122 (KR); SONG, Min Sun, Daejeon 34122 (KR)
(74) Representative: Plasseraud IP
(86) International application number: PCT/KR2025/004901
(87) International publication number: WO 2025/263778

(57) **Abstract**

According to some embodiments, a battery management device includes an interface configured to acquire battery data of a battery and a controller configured to extract physical parameters of the battery based on the battery data, classify a state of the battery corresponding to the physical parameters using a first model trained by a supervised learning algorithm for a plurality of pieces of degradation experiment data for the battery, and calculate a probability that the state of the battery is an abnormal state using a second model fitted by a classification result of the first model.

## Description

### TECHNICAL FIELD

### Cross-reference to Related Applications

This application claims priority from Korean Patent Application No. 10-2024-0080287, filed on June 20, 2024, the disclosure of which is incorporated by reference herein.

### Technical Field

Embodiments disclosed herein relate to a battery management device, a battery management method, and a battery management system.

### BACKGROUND ART

In recent years, research and development for secondary batteries have been actively conducted. Here, secondary batteries are batteries capable of being recharged and discharged, and may be interpreted to encompass both conventional Ni/Cd batteries, Ni/MH batteries, or the like, and recent lithium ion batteries. Among secondary batteries, lithium ion batteries may have a higher energy density than conventional Ni/Cd batteries, Ni/MH batteries, or the like, and may be manufactured to be small and lightweight, so the lithium ion batteries may have high usability as a power source for mobile devices. In recent years, the lithium ion batteries have expanded their range of use to power sources for electric vehicles, making the batteries attract attention as a next-generation energy storage medium.

"State of Health" (SOH) may indicate a remaining life of a battery, current performance state, and the like. The SOH of a battery may tend to rapidly decrease under certain situations. In the related art, a SOH value is periodically measured, and then only a state at a current time point may be confirmed based on a resulting slope. Since a battery abnormality due to a decrease in SOH may cause inconvenience and risk to a user, it may be necessary to predict a time point of SOH decrease in advance, but the methods in the related art may pose a problem in that such a prediction is difficult.

### DISCLOSURE OF THE INVENTION

### TECHNICAL PROBLEM

One of the objects of the embodiments disclosed herein includes providing a battery management device, a battery management method, and a battery management system capable of estimating a time point of occurrence of an abnormal state regarding SOH reduction based on physical parameters of a battery.

The technical objectives of the embodiments disclosed herein are not limited to those mentioned above, and other technical objectives not mentioned will be clearly understood by those skilled in the art from the following descriptions.

### TECHNICAL SOLUTION

According to some embodiments, a battery management device includes an interface configured to acquire battery data of a battery and a controller configured to extract physical parameters of the battery based on the battery data, classify a state of the battery corresponding to the physical parameters using a first model trained by a supervised learning algorithm for a plurality of pieces of degradation experiment data for the battery, and calculate a probability that the state of the battery is an abnormal state using a second model fitted by a classification result of the first model.

According to some embodiments, the first model may be configured to be trained based on the physical parameters extracted from each of the plurality of pieces of degradation experiment data and abnormality labeling data added to the plurality of pieces of degradation experiment data in advance.

According to some embodiments, the physical parameters may include a first feature and a second feature used for training the first model, and the first feature may include loss of active material (LAM) and the second feature includes loss of lithium source (LLI).

According to some embodiments, the controller may be configured to derive a first open circuit voltage (OCV) value at a beginning-of-life (BOL) time point and a second OCV value at a middle-of-life (MOL) time point based on the battery data and extract the physical parameters based on the first OCV value and the second OCV value.

According to some embodiments, the second model may include a logistic regression model trained to calculate the probability based on the physical parameters and the state of the battery.

According to some embodiments, the controller may be further configured to provide a notification function to a user of the battery based on the state of the battery and the probability.

According to some embodiments, the controller may be configured to provide the user with a time point at which the state of the battery is expected to become an abnormal state based on the state of the battery and the probability.

According to some embodiments, a battery management method includes acquiring battery data of a battery, extracting physical parameters of the battery based on the battery data, classifying a state of the battery corresponding to the physical parameters using a first model trained by a supervised learning algorithm for a plurality of pieces of degradation experiment data for the battery, and calculating a probability that the state of the battery is an abnormal state using a second model fitted by a classification result of the first model.

According to some embodiments, the first model may be configured to be trained based on the physical parameters extracted from each of the plurality of pieces of degradation experiment data and abnormality labeling data added to the plurality of pieces of degradation experiment data in advance.

According to some embodiments, the physical parameters may include a first feature and a second feature used for training the first model, and the first feature may include loss of active material (LAM) and the second feature includes loss of lithium source (LLI).

According to some embodiments, the extracting of physical parameters may include deriving a first open circuit voltage (OCV) value at a beginning-of-life (BOL) time point and a second OCV value at a middle-of-life (MOL) time point based on the battery data and extracting the physical parameters based on the first OCV value and the second OCV value.

According to some embodiments, the second model may include a logistic regression model trained to calculate the probability based on the physical parameters and the state of the battery.

According to some embodiments, the battery management method may further include providing a notification function to a user of the battery based on the state of the battery and the probability.

According to some embodiments, the providing of the notification function may include providing the user with a time point at which the state of the battery is expected to become an abnormal state based on the state of the battery and the probability.

According to some embodiments, a battery management system includes a battery, a charging/discharging device configured to charge and discharge the battery, and a battery management device configured to acquire battery data of a battery, extract physical parameters of the battery based on the battery data, classify a state of the battery corresponding to the physical parameters using a first model trained by a supervised learning algorithm for a plurality of pieces of degradation experiment data for the battery, and calculate a probability that the state of the battery is an abnormal state using a second model fitted by a classification result of the first model.

### ADVANTAGEOUS EFFECTS

According to the embodiments disclosed herein, it is possible to provide a battery management device, a battery management method, and a battery management system capable of estimating a time point of occurrence of an abnormal state regarding SOH reduction based on physical parameters of a battery.

The technical effects according to the embodiments disclosed herein are not limited to those mentioned above, and other effects not mentioned will be clearly understood by those skilled in the art from the disclosure herein.

### BRIEF DESCRIPTION OF THE DRAWINGS

FIG. 1 illustrates elements constituting a battery management system according to some embodiments.
FIG. 2 illustrates elements constituting a battery management device according to some embodiments.
FIG. 3 illustrates a conventional technique of determining a battery abnormality based on a SOH slope.
FIG. 4 illustrates a process of training an AI model according to some embodiments and a process of calculating a battery state and a probability of abnormality using the AI model.
FIG. 5 illustrates a method of training a first model using physical parameters of a battery according to some embodiments.
FIG. 6 illustrates a method of training the second model using classification results of the first model according to some embodiments.
FIG. 7 illustrates steps constituting a battery management method according to some embodiments.

### MODE FOR CARRYING OUT THE INVENTION

Hereinafter, embodiments disclosed in herein will be described with reference to the accompanying drawings. However, this is not intended to limit the disclosure herein to the specific embodiments, and it is to be construed to include various modifications, equivalents, and/or alternatives of embodiments disclosed herein.

It should be appreciated that embodiments herein and the terms used therein are not intended to limit the technological features set forth herein to particular embodiments and include various changes, equivalents, or replacements for a corresponding embodiment. With regard to the description of the drawings, similar or related reference numerals may be used to refer to similar or related elements. It is to be understood that a singular form of a noun corresponding to an item may include one or more of the things, unless the relevant context clearly indicates otherwise.

As used herein, each of phrases such as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. Terms such as "1st" and "2nd," "first," "second," "A." "B," "(a)," or "(b)" may be used to simply distinguish a corresponding component from another, and do not limit the components in other aspects (e.g., importance or order) unless specifically stated otherwise.

In the present specification, it is to be understood that if an element (e.g., a first element) is referred to, with or without the term "operatively" or "communicatively," as "connected to," "coupled to," or "in contact with" another element (e.g., a second element), it means that the element may be connected to the other element directly (e.g., by wire or wirelessly) or indirectly (e.g., via a third element).

A method according to various embodiments disclosed herein may be included and provided in a computer program product. The computer program product may be traded as a product between a seller and a buyer. The computer program product may be distributed in the form of a machine-readable storage medium (e.g., a compact disc read only memory and CD-ROM), or be distributed (e.g., downloaded or uploaded) online via an application store, or between two operator devices directly. If distributed online, at least part of the computer program product may be temporarily generated or at least temporarily stored in the machine-readable storage medium, such as memory of the manufacturer's server, a server of the application store, or a relay server.

According to embodiments disclosed herein, each component (e.g., a module or a program) of the above-described components may include a single entity or multiple entities, and some of the plurality of entities may be disposed separately from other components. According to embodiments disclosed herein, one or more components or operations of the above-described components may be omitted, or one or more other components or operations may be added. Alternatively or additionally, a plurality of components (e.g., modules or programs) may be integrated into a single component. In such a case, the integrated component may still perform one or more functions of each of the plurality of components in the same or similar manner as those performed by a corresponding one of the plurality of components before the integration. According to embodiments disclosed herein, operations performed by the module, the program, or another component may be carried out sequentially, in parallel, repeatedly, or heuristically, or one or more of the operations may be executed in a different order or omitted, or one or more other operations may be added.

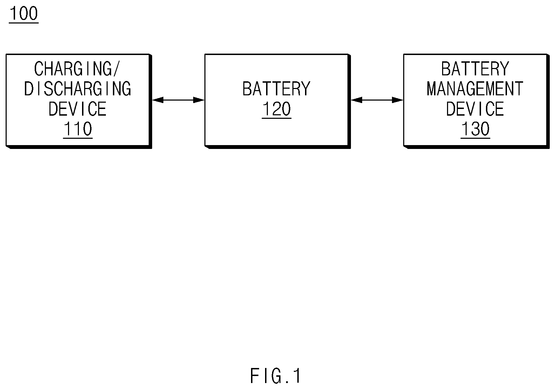

FIG. 1 may illustrate elements constituting a battery management system according to some embodiments.

Referring to FIG. 1, a battery management system 100 may include a charging/discharging device 110, a battery 120, and a battery management device 130. However, the battery management system is not limited thereto, and some components may be omitted from the battery management system 100, or other general-purpose components may be further included in the battery management system 100.

The charging/discharging device 110 may be configured to charge or discharge the battery 120. For example, the charging/discharging device 110 may include a power supply device, and the like. The charging/discharging device 110 may apply charge/discharge cycles to the battery 120 to perform a degradation experiment of the battery 120. According to an embodiment, the charging/discharging device 110 may include an electric power device, and the electric power device may include a mobility device such as an electric vehicle (EV), a hybrid electric vehicle (HEV), an electric bike, or the like.

The battery 120 may include a battery pack or the like that is a management target of the system 100. The battery pack of the battery 120 may include a plurality of battery modules, and each battery module may include a plurality of battery cells. According to an embodiment, the battery 120 may be mounted on various types of mobility devices. Charge/discharge cycles by the charging/discharging device 110 may be applied to the battery 120 to artificially form various degradation scenarios.

The battery management device 130 may perform operations for diagnosing or managing the battery 120. The battery management device 130 may acquire battery data of the battery 120 and diagnose or manage a state of the battery 120 to be diagnosed based on the battery data. According to an embodiment, the battery management device 130 may include a battery management system (BMS) configured with the battery 120 in an on-board manner, and/or an external device remotely positioned with the battery 120 in an off-board manner. The external device may include a charger of battery charging stations, a battery diagnostic device, a cloud computing server, or the like.

The battery management system 100 may further include a management server. The management server may manage management results of the battery management device 130. The management server may exchange data with the battery management device 130 via wired/wireless communication. When a defect in the battery 120 is diagnosed or its lifespan is predicted, the results may be transmitted to the management server and recorded in a database. According to an embodiment, the battery management device 130 may perform diagnostic operations by executing battery management software, and the management server may provide update information about the battery management software to the battery diagnostic device 130.

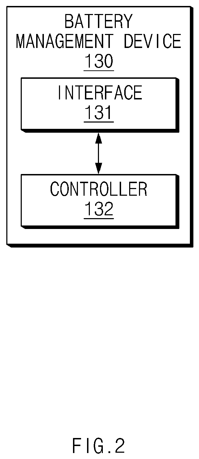

FIG. 2 may illustrate elements constituting a battery management device according to some embodiments.

Referring to FIG. 2, the battery management device 130 may include an interface 131 and a controller 132. However, the battery management device is not limited thereto, and some components may be omitted from the battery management device 130, or other general-purpose components may be further included in the battery management device 130.

The interface 131 may acquire battery data of the battery 120. According to an embodiment, the interface 131 may include a communication unit configured to receive battery data and/or a sensor unit configured to measure battery data. According to an embodiment, when the battery management device 130 is implemented in an off-board form, the communication unit may receive battery data in a manner such as wired data communication, wireless data communication, or the like. Alternatively, when the battery management device 130 is implemented in the on-board form, the sensor unit may be configured to measure values such as voltage, current, temperature, and resistance associated with the battery 120.

The controller 132 may have a structure for executing commands that implement operations of the battery management device 130. The controller 132 may be implemented as an array of a number of logic gates for processing various operations or as a general-purpose microprocessor, and may consist of a single processor or a plurality of processors. For example, the controller 132 may be implemented in the form of at least one of a microprocessor, a central processing unit (CPU), a graphics processing unit (GPU), and an application processor (AP).

The controller 132 may operate together with a memory configured to store various data, commands, mobile applications, computer programs, and the like. The memory may be configured separately from or integral with the controller 132. The controller 132 may process various operations by executing commands stored in the memory. The memory may be implemented in a form of a non-volatile device such as a read-only memory (ROM), a programmable ROM (PROM), an erasable programmable ROM (EPROM), an electrically erasable PROM (EEPROM), a flash memory, a parallel random-access memory (PRAM), a magneto-resistive RAM (MRAM), a resistive RAM (RRAM), a ferroelectric RAM (FRAM), or the like, or a volatile device such as a dynamic RAM (DRAM), a static RAM (SRAM), a synchronous dynamic RAM (SDRAM), a parallel RAM (PRAM), or the like, or may be implemented in a form of a hard disk drive (HDD), a solid state drive (SSD), a secure digital (SD), Micro-SD, or a combined form thereof.

The interface 131 may be configured to acquire battery data of the battery 120. The battery data may include a voltage, current, temperature, resistance, and the like of the battery 120. The battery data may be acquired in units such as cells, modules, and packs of the battery 120. The battery data may include time series data, which contains values collected at regular intervals. According to an embodiment, the battery data may include measurement data acquired while the battery 120 is being charged or discharged by the charging/discharging device110.

The controller 132 may be configured to extract physical parameters of the battery 120 based on the battery data. The physical parameters may refer to parameters representing physical characteristics of the battery 120. For example, the physical parameters may include loss of active material (LAM), loss of lithium source (LLI), and the like. The physical parameters may serve as machine learning features utilized to identify a state in which the SOH of the battery 120 is rapidly decreasing.

The controller 132 may be configured to classify the state of the battery 120 corresponding to the physical parameters using a first model trained by a supervised learning algorithm for a plurality of pieces of degradation experiment data for the battery 120. The plurality of pieces of degradation experiment data may be generated by repeatedly charging and discharging the battery 120 under different degradation conditions. For example, the charging/discharging device 110 may apply different charge/discharge cycles to the battery 120, and during this time, data output by the battery 120 may be collected as the plurality of pieces of degradation experiment data. For example, the plurality of pieces of degradation experiment data may include different combinations of loss of active material (LAM) values and loss of lithium source (LLI) values, and each combination may be assigned a labeling value. The labeling value may indicate whether the battery 120 is abnormal depending on each degradation condition. The plurality of pieces of degradation experiment data may be used as training data to train the first model. For example, the first model may include a support vector machine (SVM) model. After completing training, the first model may receive physical parameters as inputs and output a corresponding battery state.

The controller 132 may be configured to calculate a probability that the state of the battery 120 is an abnormal state using a second model fitted by a classification result of the first model. When the training of the first model is completed, fitting of the second model may be performed using the first model. According to the fitting, a probability of abnormality of the battery 120 output by the second model may be optimized. For example, the second model may be trained to output the probability of abnormality of the battery 120 based on the physical parameters and the output of the first model using logistic regression. By referring to the outputs of the first and second models, it may be checked whether there is abnormality in the current battery 120, and when there is no abnormality, the probability of abnormality in the battery 120 may be estimated.

According to an embodiment, the first model may be configured to be trained based on the physical parameters extracted from each of the plurality of pieces of degradation experiment data and abnormality labeling data added to the plurality of pieces of degradation experiment data in advance. The abnormality labeling data may be added to the plurality of pieces of degradation experiment data in advance, and through the abnormality labeling data, it may be determined whether a degradation experiment condition of each piece of degradation experiment data causes an abnormality or defect in the battery 120. The state of the battery 120 classified by the abnormality labeling data may be expressed by physical parameters. The first model may learn a relationship between physical parameters and the state of the battery 120.

According to an embodiment, the physical parameters may include a first feature and a second feature used for training the first model, and the first feature may include loss of active material (LAM) and the second feature may include loss of lithium source (LLI). The physical parameters may represent a combination of an LAM value and an LLI value, and the first model may learn how the combination of the LAM value and the LLI value is related to the state of the battery 120.

According to an embodiment, the controller 132 may be configured to derive a first open circuit voltage (OCV) value at a beginning-of-life (BOL) time point and a second OCV value at a middle-of-life (MOL) time point based on the battery data and extract the physical parameters based on the first OCV value and the second OCV value. Based on a OCV difference at the BOL time point and the MOL time point, the LAM value and the LLI value may be calculated.

According to an embodiment, the second model may include a logistic regression model that is trained to calculate a probability based on the physical parameters and the state of the battery 120. When the training of the first model is completed, the first model may output the state of the battery 120. In addition to the state, by considering the physical parameters together, the second model may output the probability of abnormality of the battery 120. Alternatively, other appropriate models other than the logistic regression model may be applied to the second model.

According to an embodiment, the controller 132 may be further configured to provide a notification function to the user associated with the battery 120 based on the state of the battery 120 and the probability. For example, a notification function may be provided to a user's mobile terminal and/or a vehicle equipped with the battery 120. The notification content may include whether there is currently an abnormality in the battery 120 and the probability of abnormality.

According to an embodiment, the controller 132 may be configured to provide the user with a time point at which the state of the battery 120 is expected to become an abnormal state based on the state of the battery 120 and the probability. Although the current state of the battery 120 is not an abnormal state, when the probability of abnormality of the battery 120 is high, the state of the battery 120 may become an abnormal state in the near future. Considering the physical parameters and the probability of abnormality of the battery, the expected time point of an abnormal state may be calculated. According to an embodiment, the second model may be additionally trained to output the expected time point together with the probability of abnormality of the battery 120. Alternatively, the controller 132 may be configured to calculate the expected time of an abnormal state by additionally introducing a third model separate from the first and second models. For example, the third model may be configured to calculate an earlier expected time point when the probability of abnormality is higher.

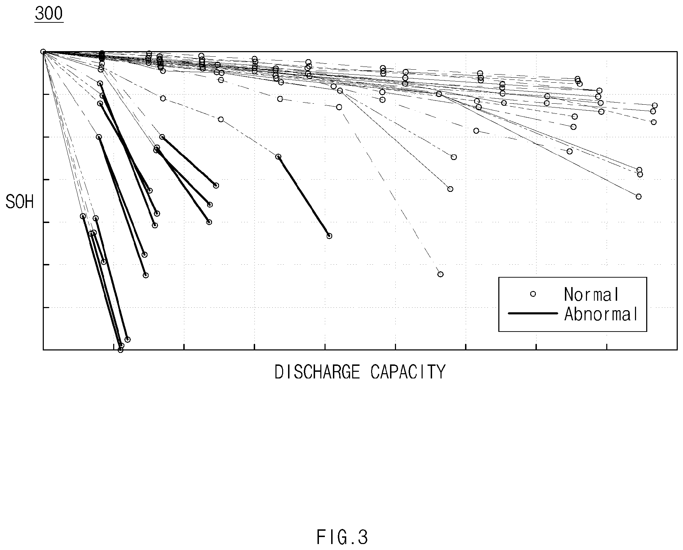

FIG. 3 illustrates a conventional technique of determining a battery abnormality based on a SOH slope.

Referring to FIG. 3, a graph 300 exemplifying a conventional technique of determining a battery abnormality based on an SOH slope may be illustrated.

In the conventional technique, a method of checking a trend of fluctuation in the SOH value as the battery is discharged is used, and when the size of the SOH slope exceeds a specific value and/or a specific ratio, it is determined that an abnormal state occurs.

However, since the conventional technique requires accumulated past data to identify the trend of the SOH slope, it may be difficult to determine an abnormality in a situation where only the data at the current time point is handled. Moreover, even when past data is taken into account, only the current state may be determined, and it is difficult to predict the state at a future time point.

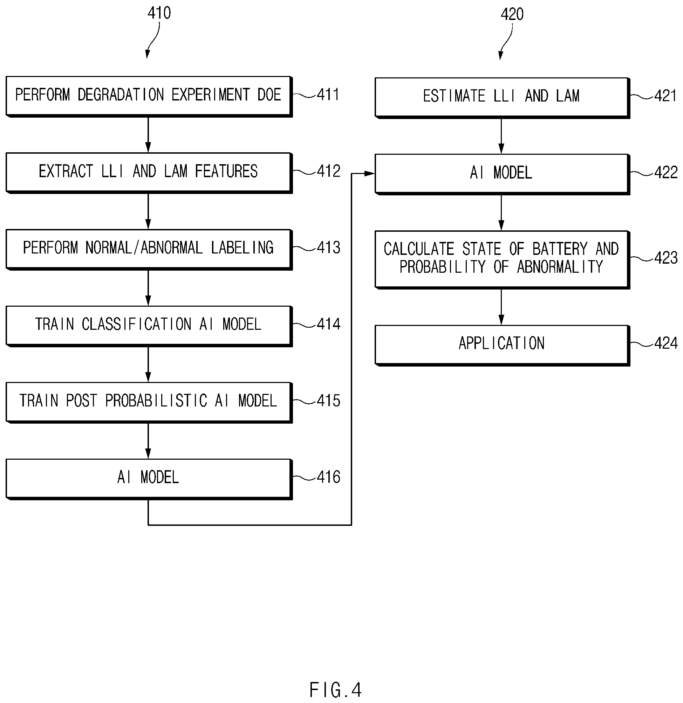

FIG. 4 illustrates a process of training an AI model according to some embodiments and a process of calculating a battery state and a probability of abnormality using the AI model.

Referring to FIG. 4, a process 410 of training an AI model and a process 420 of calculating a battery state and a probability of abnormality using the AI model may be illustrated.

In step 411, a plurality of pieces of degradation experiment data may be collected using various types of design-of-experiments (DOEs). In step 412, physical parameters such as LLI and LAM may be extracted for each experiment. These may be used as features for AI model learning. In step 413, a labeling task may be performed to distinguish between a normal state and an abnormal state for each experiment. The labeling task may be prepared in advance before the process of training the model.

In step 414, training of a classification AI model may be performed. For a plurality of DOEs, the classification AI model may learn how the combinations of LLI and LAM values are associated with the labeled battery state. In step 415, a probabilistic AI model providing a probability of abnormality may be trained. When both the classification AI model and the probabilistic AI model are trained, model training may be completed in step 416.

In step 421, physical parameters such as the LLI value and the LAM value may be extracted from the battery that is the target of state estimation. In step 422, the physical parameters may be input into the AI model. In step 423, the AI model may provide the state of the battery and the probability of abnormality. In step 424, a notification function to the user may be provided based on the state of the battery and the probability of abnormality. The notification function may notify the user of the current state of the battery and the expected time point of an abnormality.

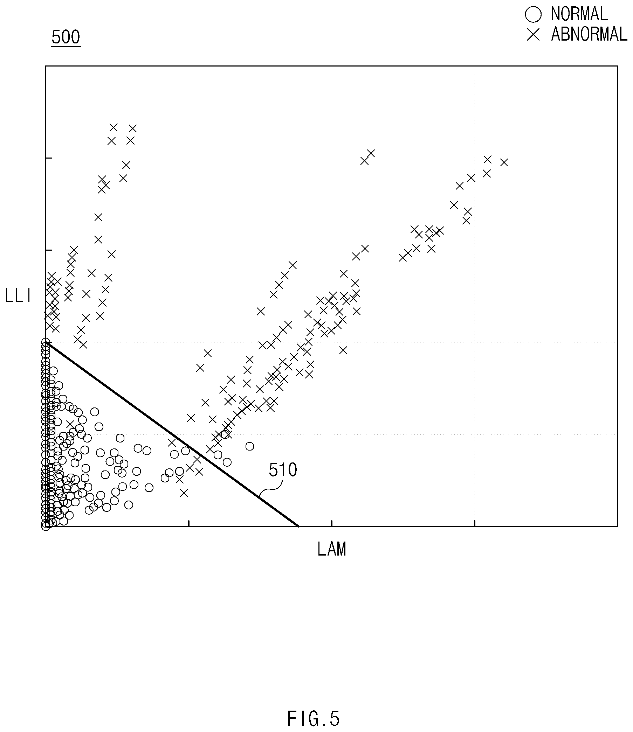

FIG. 5 illustrates a method of training the first model using physical parameters of the battery according to some embodiments.

Referring to FIG. 5, a graph 500 exemplifying the method of training the first model using physical parameters of the battery may be illustrated.

Referring to the graph 500, data points corresponding to combinations of LAM values on a horizontal axis and LLI values on a vertical axis may be plotted on a two-dimensional graph. Each of the plotted data points may correspond to a plurality of pieces of degradation experiment data. The data points may be labeled as either normal or abnormal.

The first model may set a baseline 510 based on the distribution of data points. The baseline 510 may be used to distinguish whether a combination of an LAM value and an LLI value is normal or abnormal. The baseline 510 may be formed not only in a straight-line shape, but also in various curved shapes or a combination of straight and curved shapes. The first model may adjust the position of the baseline 510 through training to optimally classify data points of the plurality of pieces of degradation experiment data.

When the training of the first model is completed, the position of the baseline 510 may be determined. Then, when a combination of an LAM value and an LLI value of a target battery to be estimated is input into the first model, a state of the target battery to be estimated may be classified by comparing a data point of the combination with the baseline 510.

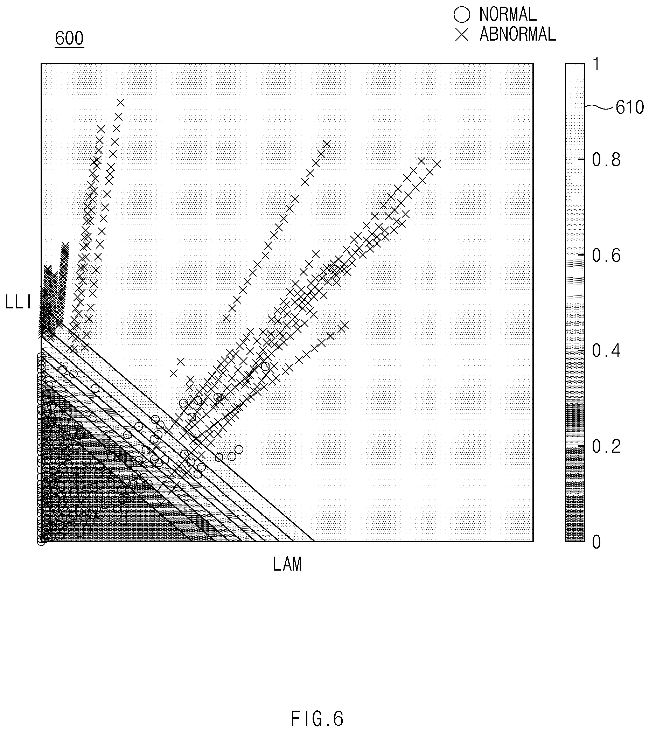

FIG. 6 illustrates a method of training the second model using classification results of the first model according to some embodiments.

Referring to FIG. 6, a graph 600 exemplifying the method of training the second model using the classification results of the first model may be illustrated.

A two-dimensional region of the graph 600 may be divided into different colors according to the probability of abnormality. For example, a legend 610 may represent a matching relationship between color and the probability of abnormality. The two-dimensional region of the graph 600 may be formed based on the baseline 510 of the graph 500 in FIG. 5.

For example, when the training of the first model is completed, the position of the baseline 510 may be determined. The position of the baseline 510 may correspond to the probability of abnormality of about 0.5. Therefore, the second model may be trained to adjust a boundary line representing the probability of abnormality of 0.5 to be identical to the position of the baseline 510. When the boundary line representing the probability of abnormality of 0.5 is determined, boundary lines corresponding to the probability of abnormality of other values may also be adjusted based on the parallel movement with respect to the boundary line.

When the positions of the boundary lines representing respective probabilities of abnormality are determined, the training of the second model may be completed. When a combination of an LAM value and an LLI value of the target battery to be estimated is input into the second model, it may first be confirmed whether the corresponding combination is classified as normal or abnormal. When the corresponding combination is classified as normal, a value of the probability of abnormality may be provided based on the boundary lines of the second model. According to an embodiment, the second model may be configured to provide values of probabilities of abnormality for the combinations of LAM values and LLI values that are classified as abnormal.

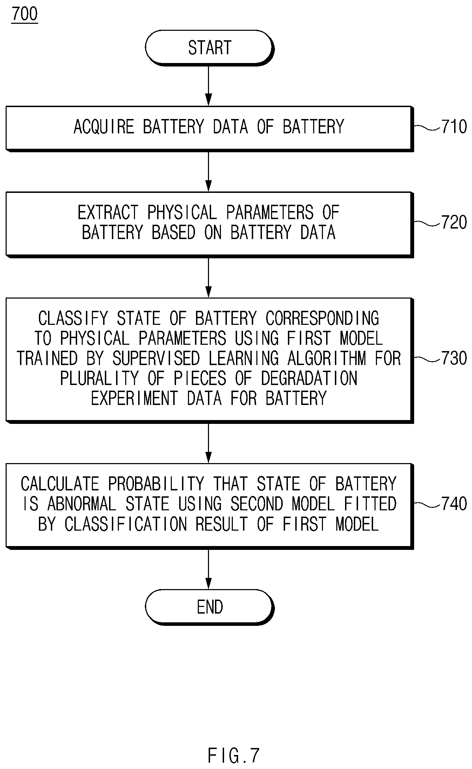

FIG. 7 illustrates steps constituting a battery management method according to some embodiments.

Referring to FIG. 7, a battery management method 700 may include steps 710 to 740. However, the battery inspection method is not limited thereto, and some steps may be omitted or other general steps may be added, and the steps of the battery management method 700 may be executed in a different order than the illustrated order.

The battery management method 700 may include steps that are processed in time series in the battery management device 130. Therefore, even when the content is omitted below, the content described above for the battery management device 130 may be equally applied to the battery management method 700.

Steps 710 to 740 of the battery management method 700 may be performed by the interface 131 and controller 132 of the battery management device 130.

In step 710, the battery management device 130 may perform a step of acquiring battery data of a battery.

In step 720, the battery management device 130 may perform a step of extracting physical parameters of the battery based on the battery data.

In step 730, the battery management device 130 may perform a step of classifying the state of the battery corresponding to the physical parameters using a first model trained by a supervised learning algorithm for a plurality of pieces of degradation experiment data for the battery.

In step 740, the battery management device 130 may perform a step of calculating a probability that the state of the battery is an abnormal state using a second model fitted by a classification result of the first model.

According to an embodiment, the battery management method 700 may be implemented in the form of a computer program stored in a computer-readable storage medium. That is, the computer program may include commands for implementing the battery management method 700, and the commands of the program may be stored in the computer-readable storage medium. The computer program may include a mobile application.

According to an embodiment, a computer-readable storage medium may include magnetic media such as hard disks, floppy disks, and magnetic tapes, optical media such as CD-ROMs and DVDs, magneto-optical media such as floptical disks, and a hardware device specially configured to store and execute computer program instructions, such as ROM, RAM, flash memory, or the like. Computer program instructions may include machine language code generated by a compiler and high-level language code that may be executed by a computer using an interpreter, or the like.

Terms such as "include," "comprise," or "have" described above mean that the corresponding component can be present unless otherwise stated, and thus it should be construed that other components may be further included rather than excluding other components. All terms including technical or scientific terms have the same meaning as commonly understood by those of ordinary skill in the art to which embodiments disclosed herein belong, unless otherwise defined. Terms commonly used such as those defined in dictionaries should be interpreted as having a meaning that is consistent with their meaning in the context of the related art and will not be interpreted in an idealized or overly formal sense unless expressly so defined herein.

The above description is merely an example of the technical idea disclosed herein, and those with ordinary skill in the art to which the embodiments disclosed herein belong may make various modifications and variations without departing from the essential characteristics of the embodiments disclosed herein. Accordingly, the embodiments disclosed herein are not intended to limit the technical ideas of the embodiments disclosed herein but rather to explain them, and the scope of the technical ideas disclosed herein is not limited by these embodiments. The scope of protection disclosed herein should be interpreted by the accompanying claims, and all technical ideas within the scope equivalent thereto should be construed as being included in the scope of rights herein.

### (Reference Signs List)

| | | | |
|---|---|---|---|
| 100: | Battery managementsystem | 110: | Charging/discharging device |
| 120: | Battery | 130: | Battery management device |
| 131: | Interface | 132: | Controller |

## Claims

1. A battery management device comprising:
an interface configured to acquire battery data of a battery; and
a controller configured to:
extract physical parameters of the battery based on the battery data;
classify a state of the battery corresponding to the physical parameters using a first model trained by a supervised learning algorithm for a plurality of pieces of degradation experiment data for the battery; and
calculate a probability that the state of the battery is an abnormal state using a second model fitted by a classification result of the first model.

2. The battery management device of claim 1, wherein the first model is configured to be trained based on the physical parameters extracted from each of the plurality of pieces of degradation experiment data and abnormality labeling data added to the plurality of pieces of degradation experiment data in advance.

3. The battery management device of claim 1, wherein the physical parameters include a first feature and a second feature used for training the first model, and
the first feature includes loss of active material (LAM) and the second feature includes loss of lithium source (LLI) .

4. The battery management device of claim 1, wherein the controller is configured to:
derive a first open circuit voltage (OCV) value at a beginning-of-life (BOL) time point and a second OCV value at a middle-of-life (MOL) time point based on the battery data; and
extract the physical parameters based on the first OCV value and the second OCV value.

5. The battery management device of claim 1, wherein the second model includes a logistic regression model trained to calculate the probability based on the physical parameters and the state of the battery.

6. The battery management device of claim 1, wherein the controller is further configured to provide a notification function to a user of the battery based on the state of the battery and the probability.

7. The battery management device of claim 6, wherein the controller is configured to provide the user with a time point at which the state of the battery is expected to become an abnormal state based on the state of the battery and the probability.

8. A battery management method comprising:
acquiring battery data of a battery;
extracting physical parameters of the battery based on the battery data;
classifying a state of the battery corresponding to the physical parameters using a first model trained by a supervised learning algorithm for a plurality of pieces of degradation experiment data for the battery; and
calculating a probability that the state of the battery is an abnormal state using a second model fitted by a classification result of the first model.

9. The battery management method of claim 8, wherein the first model is configured to be trained based on the physical parameters extracted from each of the plurality of pieces of degradation experiment data and abnormality labeling data added to the plurality of pieces of degradation experiment data in advance.

10. The battery management method of claim 8, wherein the physical parameters include a first feature and a second feature used for training the first model, and
the first feature includes loss of active material (LAM) and the second feature includes loss of lithium source (LLI).

11. The battery management method of claim 8, wherein the extracting of physical parameters includes:
deriving a first open circuit voltage (OCV) value at a beginning-of-life (BOL) time point and a second OCV value at a middle-of-life (MOL) time point based on the battery data; and
extracting the physical parameters based on the first OCV value and the second OCV value.

12. The battery management method of claim 8, wherein the second model includes a logistic regression model trained to calculate the probability based on the physical parameters and the state of the battery.

13. The battery management method of claim 8, further comprising providing a notification function to a user of the battery based on the state of the battery and the probability.

14. The battery management method of claim 13, wherein the providing of the notification function includes providing the user with a time point at which the state of the battery is expected to become an abnormal state based on the state of the battery and the probability.

15. A battery management system comprising:
a battery;
a charging/discharging device configured to charge and discharge the battery; and
a battery management device configured to acquire battery data of a battery, extract physical parameters of the battery based on the battery data, classify a state of the battery corresponding to the physical parameters using a first model trained by a supervised learning algorithm for a plurality of pieces of degradation experiment data for the battery, and calculate a probability that the state of the battery is an abnormal state using a second model fitted by a classification result of the first model.
